Europäisches Patentamt

European Patent Office

Office européen des brevets

(11) Publication number: **0 265 895 B1**

## EUROPEAN PATENT SPECIFICATION

(45) Date of publication of patent specification: **10.02.93**    (51) Int. Cl.⁵: **C23C 18/40**, C23C 18/16

(21) Application number: **87115705.3**

(22) Date of filing: **27.10.87**

(54) **Method for electrolessly depositing high quality copper.**

(30) Priority: **31.10.86 US 926363**

(43) Date of publication of application:
**04.05.88 Bulletin 88/18**

(45) Publication of the grant of the patent:
**10.02.93 Bulletin 93/06**

(84) Designated Contracting States:
**ES**

(56) References cited:
**FR-A- 2 436 192**

**Journal of the Electrochemical Society.: M. Stern et al " Electrochemical Polarization ", vol.104, No. 1 ( 1957 ) January , pages 56-63.**

(73) Proprietor: **AMP-AKZO CORPORATION (a Delaware corp.)**
**710 Dawson Drive**
**Newark, Delaware 197113(US)**

(72) Inventor: **Hughes, Rowan**
**22800 Rockside Road Appt. 406**
**Bedford, OH 44146(US)**
Inventor: **Paunovic, Milan**
**78 Shadyside Avenue**
**Port Washington, NY 11050(US)**
Inventor: **Zeblisky, Rudolf J.**
**41 Glenwood Drive**
**Hauppauge, NY 11787(US)**

(74) Representative: **Königseder-Egerer, Claudia**
**Zugspitzstrasse 65**
**W-8104 Grainau(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

Electroless metal deposition solutions comprise metal ions and a reducing agent for the metal ions. The reducing agent oxidizes on a catalytic surface, and provides electrons to the surface. These electrons, in turn, reduce the metal ions to the metal on the surface.

This process may be written in the form of a chemical equation

$$Red + Me^{n+} = Ox + Me^o.$$

The term 'Red' means the reducing agent, '$Me^{n+}$' refers to the metal ion, 'Ox' means the oxidized form of the reducing agent, and '$Me^o$' refers to the reduced metal. This equation can be split into equations describing the two half reactions

$$Red = Ox + ne^- \text{ and}$$
$$Me^{n+} + ne^- = Me^o$$

where 'n' is the valence of the metal ion and '$e^-$' designates an electron.

In many electroless copper deposition solutions the reducing agent, Red, is an alkaline formaldehyde, an aqueous formaldehyde solution with a pH between 10 and 14. In the case of alkaline formaldehyde, Ox would be formate ion. $Me^{n+}$ refers to the metal ion, e.g., a Cu(II) ion, and $Me^o$ refers to the metal, e.g., copper. These general equations may be rewritten more specifically for a system with copper ions and alkaline formaldehyde as

$$2HCHO + 4OH^- = 2HCOO^- + 2H_2O + H_2 + 2e^-, \text{ and}$$
$$CuL^{n+2} + 2e^- = Cu^o + L^n.$$

'L' designates the ligand necessary to prevent precipitation of basic copper compounds in alkaline solution, and 'n' refers to the valence of the ligand ions.

The half reaction of formaldehyde with hydroxide to produce electrons does not take place homogenously in the bulk solution. It is a heterogeneous reaction which takes place on catalytic conductive surfaces such as copper.

This reaction is called an anodic reaction. The half reaction for copper ions from the copper-ligand complex to copper metal is known as the cathodic reaction.

At the thermodynamic equilibrium, the rate of the anodic reaction, in the forward direction,

$$Red = Ox + e^-,$$

is equal to and opposite the rate of the same reaction in the opposite direction,

$$Ox + e^- = Red;$$

and the potential of the electrode surface is the equilibrium potential. When the potential of the electrode surface is shifted to a more positive potential either by imposing a potential on the electrode from an external power supply, or by a second reaction with a more positive equilibrium potential simultaneously taking place on the same electrode, the rate of the forward reaction is no longer in equilibrium with the rate of the reverse reaction. The rate of the forward reaction increases or decreases as a function of the shift of the potential away from the thermodynamic equilibrium potential.

In many electrochemical processes, the anodic and cathodic reactions take place on separate electrodes, the anode and the cathode.

In electroless metal deposition, the anodic and cathodic reactions take place on the same surface, so that at any instant one point on the surface may be considered anodic and another point cathodic, and the rate of the anodic reaction may be assumed to be equal to the rate of the cathodic reaction, with the electrons produced in the anodic reaction consumed in the cathodic reaction. In electroless metal deposition, the cathodic reaction,

$$Me^{n+} + ne^- = Me^o,$$

taking place on the same electrode with the anodic reaction shifts the anodic reaction to more positive potential (and the cathodic reaction to a potential more negative than its thermodynamic equilibrium potential). The potential where both the forward anodic and cathodic reactions are preceeding without an external voltage supply is a mixed potential, $E_{mp}$, and is the deposition potential for electroless deposition.

At the mixed potential, the rates of the anodic and cathodic reactions are equal to each other, and can be measured as the deposition rate of the metal as $mg/cm^2/hr$ which by Faraday's Law can be expressed as $mA/cm^2$.

Copper deposits on substrates produced by electroless deposition or electroless deposition re-inforced by electroplating are an important part of many processes used for the manufacture of printed circuits. Additive or fully additive printed wiring boards are made with a process which uses 100% electroless formed copper. In order to provide reliable printed circuits for military applications, there has been developed a specification, Mil Spec. P-55110-D, which tests and measures the performance of printed circuits when subjected to conditions and environments they will be exposed to during manufacture and use. This specification is basically a functional test which evaluates and tests the physical properties of all the materials used to make a printed circuit. The criteria for printed circuits in military and some commercial applications are based on the ability to meet the requirements of this specification.

Heretofore, electroless copper deposits on FR-4 epoxy glass material using the fully-additive method of making printed circuits have not been able to pass the Mil. Spec. P-55110-D thermal stress test. When exposed to this test, the plated-through holes would fracture during the 10 seconds exposure to the molten solder, usually at the intersections of the hole wall with the surface, the corners of the holes. These fractures (corner cracks) would usually fill with solder providing good electrical conductivity through the hole, but the integrity of the copper deposits were suspect and not acceptable for many applications. Although it is desirable to pass the Military thermal stress test, this has proved to be a difficult test to continuously pass in a production environment when manufacturing printed circuits. On the other hand, this test has been found to reliably predict performance of circuit boards under stress conditions encountered during use.

Prior art electroless copper formulations have been empirically derived and based on specific addition agents and conditions which were difficult to control and operate on a consistent basis. Many of the addition agents are present in parts per million or per billion and difficult to analyze and control. Furthermore, trace contaminants have been difficult to detect and have had major detrimental effects on deposition quality. The resulting copper deposits, although acceptable for some commercial applications, have not been of sufficient quality to have broad acceptance in the industry.

In addition to the normal by-products formed during operation, chemical contamination can enter the plating solution through chemical additions, water supplies, air or from the work placed in the electroless copper bath.

Many of the inorganic contaminants, such as iron, cuprous ions, silver, gold, antimony, arsenic, and many other metals and their compounds, as well as many organic contaminants, can cause deleterious results for both bath operation and the quality of the copper deposits, even when only present in parts per million concentration. For electroless copper deposition, it has been reported in US-A-4 099 974 that the concentration of the anodic reactants, formalehyde and hydroxide, above a threshold, has little effect on the copper plating rate. Therefore, the inventors of US-A-4 099 974 use only anodic reactant concentrations above the threshold. Under such conditions, copper ion concentration does effect the plating rate.

The same observation, that plating rate is largely independent of the concentration of the anodic reactants, but depends mainly on the copper concentration, has been reported by many authors. Donahue, Wong & Balla, J. Electrochemical Soc., Vol. 127, p. 2340 (1980) summarize the data from a number of sources showing the copper concentration is the major factor in the rate equation.

In other words: in electroless copper deposition solutions known and used in the art, the rate of the cathodic reaction, $CuL^{n+2} + 2e^- = Cu^o + L^n$, controls the rate of both reactions at the mixed potential.

The ductility, tensile strength and elongation needed in electroless copper plating for additive printed circuits has been widely studied. There is no agreement among the experts in the field on the numerical values of these properties necessary for additive printed circuits. However, it has been widely held that these numerical values should be maximized in order to achieve additive printed circuit boards resistant to fissure formation in the copper deposits during soldering. The only common agreement that has been achieved among the experts is that the ductility of the copper deposits improves with increasing temperature of the electroless plating solution, as reported by Grunwald, Rhodenizer & Slominski, Plating, Vol. 58, p. 1004 (1970).

By the term 'anodic reaction rate' is meant the rate of oxidation of the reducing agent on a metal surface in an electroless metal deposition solution.

By 'cathodic reaction rate' is meant the rate of reduction of metallic ions to metal on a metallic surface in an electroless deposition solution.

By the 'intrinsic anodic reaction rate', $r_a$, is meant the anodic reaction rate as measured on a metallic surface in an electroless plating solution by imposing a potential slightly more positive than the mixed potential on the metallic surface.

By the 'intrinsic cathodic reaction rate', $r_c$, is meant the cathodic rate as measured on a metallic surface in an electroless plating solution by imposing a potential slightly more negative than the mixed potential on the metallic surface.

By the 'mixed potential', $E_{mp}$, is meant the potential difference between a reference electrode and a metallic surface on which both the anodic and the cathodic reactions are proceeding, and metal is being electrolessly deposited. Unless otherwise stated, the reference electrode is a saturated calomel electrode, SCE.

By the term 'thermal stress test' is meant a test of printed circuit specimens containing plated through holes wherein the specimens are conditioned at 120°C to 150°C for a period of 2 h minimum to remove the moisture; after conditioning, the specimens are placed in a dessicator on a ceramic plate to cool; the specimens are then fluxed and floated in a solder bath (Sn 63 ± 5%, maintained at 288°C ± 5°C)for a period of 10 seconds; after stressing, the specimens are placed on a piece of insulator to cool; then microsectioned in a vertical plane at the center of the hole and examined for cracks at 50 to 100 magnitude.

A minimum of one microsection containing at least three holes is be made for each sample tested. Any cracks forming in the copper deposit on the specimens will indicate thermal stress failure.

By referring to an 'electroless plating reaction as under cathodic control' it is meant that the cathodic reaction controls the overall plating rate, i.e., the plating rate depends on the concentration of the cathodic reactants, the concentration of the metal ions, or the concentration of depolarizers for the half reaction involving the metal ions.

By referring to an 'electroless plating reaction as under anodic control' it is meant the anodic reaction controls the overall plating rate, i.e., the plating rate depends on the concentration of the anodic reactants, the concentration of the reducing agents for the metal ions, or depolarizers for the half reaction involving the reducing agents.

By the term "high quality copper" is meant copper that has small crystals with a grain size less than 10 $\mu$m and low frequency of crystal dislocation, defects and twinning. High quality copper on printed circuit boards will pass the thermal stress test.

When referring to electrolessly deposited copper, by the term "satisfactory copper quality" is meant also high quality copper.

By "fissure free copper deposits" is meant electroless copper deposits free from internal cracks or fissures or internal defects capable of causing cracks or fissures when the copper deposit is thermally stressed. "Fissure resistant copper" means copper deposits that will not form fissures or cracks when exposed to thermal stress, thermal cycling or in use.

It is an object of this invention to provide copper metal deposits with good physical properties from electroless plating solutions.

It is also an object of this invention to provide electrolessly deposited copper for printed circuit boards which is resistant to crack formation under thermal stress testing at 288°C.

It is an object of this invention to provide highly reliable printed wiring boards.

It is a further object of this invention to provide a method of operating and maintaining an electroless copper plating solution which ensures the deposition of copper having good physical properties and being free of fissures.

It is a still further object of this invention to provide a method of formulating electroless copper plating solutions that are capable of depositing copper free of fissures and resistant to cracking under thermal stresses.

According to the invention, there is provided a method for depositing copper which is essentially free of fissures on a substrate with an electroless copper deposition solution comprising copper ions, a pH-adjustor, one or more ligands for copper ions and a reducing agent for the copper ions, characterized in that the method comprises preparing said electroless copper deposition solution and operating the solution by adjusting the concentrations of anodic and cathodic reagents such that the ratio of its measured intrinsic anodic reaction rate to its measured intrinsic cathodic reaction rate is less than 1.1, whereby the anodic and cathodic reagents are bath constituents which participate in the anodic and the cathodic reaction, respectively, and influence the intrinsic cathodic reaction rate and the intrinsic anodic reaction rate, respectively; and depositing copper with said electroless deposition solution on said substrate.

The invention is based on the new and inventive concept that, in order to produce satisfactory copper, the constituents comprising the electroless copper deposition solution are present in the solution in concentrations and under operating conditions such that, at the operating temperature of the solution, the intrinsic anodic reaction rate is less than 1.1 times the intrinsic cathodic reaction rate.

In one aspect, the invention comprises a method of monitoring and controlling electroless plating solutions to obtain electrolessly formed metal deposits of high quality, characterized in that the ratio of the intrinsic reaction rates is maintained during copper deposition.

In another embodiment, the invention comprises monitoring the ratio of the intrinsic anodic and cathodic reaction rates of the electroless deposition solution, and adjusting the solution composition and/or operating conditions to maintain the intrinsic anodic reaction rate less than 110% of the intrinsic cathodic reaction rate.

In a further embodiment the invention comprises a method of controlling the commercial operation of an electroless copper deposition solution characterized in that the commercial use of said deposition solution is discontinued unless the ratio of the measured intrinsic anodic reaction rate and intrinsic cathodic reaction rate is less than 1.1.

In yet another embodiment, the invention comprises a simple method of selecting an electroless copper plating solution operating under anodic control. Formulations for solutions under anodic control can be determined by measuring the rates of electrolessly deposited copper while varying the concentration of the anodic and/or cathodic reactants. The alkaline electroless copper deposition solutions comprise copper ions, one or more ligands to stabilize the copper ions, a reducing agent capable of reducing the copper ions to metal, a pH adjusting component, and additives such as stabilizers, accelerators, ductility promoters, and surfactants.

In one embodiment of the invention, the ratio of said intrinsic reaction rates is maintained by reducing the concentration of contaminants present in the deposition bath solution, e.g., by replacing a portion of said deposition solution with an equivalent amount of such solution which is essentially free of said contaminant.

Fig. 1 is a schematic diagram of an apparatus suitable for carrying out electrochemical measurements according to the invention.

Fig. 2 is the plot of the potential applied in making the measurements vs. time as described in Example 1.

Fig. 3 is the plot of the current produced vs. the potential applied as described in Example 1.

While the invention will be described in the context of alkaline electroless plating solutions, its scope is not limited to such solutions.

Aqueous electroless copper plating solutions for use in the processes of this invention usually contain copper compounds which serve as the source of copper ions to form the copper metal deposits; reducing agents which are themselves oxidized and provide the electrons necessary to reduce the copper ions to copper metal deposits; pH adjusting compounds which provide a pH suitable for reduction of the copper ions by the reducing agents; complexing agents to solubilize the copper ions at the pH of the solutions; and additives to stabilize the solution, brighten the deposits, reduce surface tension, inhibit hydrogen inclusion in and improve the ductility of the copper metal deposits.

Among the copper compounds that are suitable as sources of copper ions are copper sulfates, copper nitrates, Cu halides, Cu acetates, Cu phosphates, Cu oxides, Cu hydroxides, basic copper sulfates, halides and cabonates and soluble copper complexes.

Cu(II) compounds are preferred, and Cu(II) sulfate and Cu(II) chloride are commonly used.

Another source of copper ions is metallic copper which may be electrochemically dissolved into the electroless plating solution, or electrochemically dissolved into an electrolyte and diffused through a membrane into the electroless plating solution.

The lower limit for the concentration of the copper compound in the electroless plating solution should be high enough to maintain the intrinsic cathodic reaction rate greater than 90% of the intrinsic anodic reaction rate.

The upper limit is the concentration where copper metal precipitates homogeneously throughout the solution instead of only forming copper deposits on pre-selected catalytic surfaces. The upper limit also depends on the stabilizer additive used to control homogeneous precipitation and the substrate being plated.

For most electroless copper plating bath formulations, the concentration will be set at a point above 0.01 molar and below 0.1 molar, and be controlled ± 10%.

Among the reducing agents that are suitable for the reduction of copper ions are formaldehyde. Formaldehyde compounds such as formaldehyde bisulfite, paraformaldehyde, and trioxane; and boron hydrides such as boranes and borohydrides such as alkali metal borohydrides.

The upper limit for the reducing agent in the electroless plating solution is the concentration at which the intrinsic anodic reaction rate is 110% the intrinsic cathodic reaction rate. The lower limit is the concentration at which copper plating on a clean copper surface doesn't occur, i.e., the plating solution is passive.

Preferably, the lower limit is the concentration at which the intrinsic anodic reaction rate is 75% to 85% of the intrinsic cathodic reaction rate. For formaldehyde and formaldehyde compounds, the limits depend on additives, pH and very strongly on the plating temperature. For most formulations, the concentration of formaldehyde will be set above 0.01 molar and below 0.25 molar and controlled between ±10% to ±30%.

Suitable pH adjusting compounds include the alkali metal hydroxides and copper oxide. In the operation of an alkaline, electroless copper plating solution, the pH usually drops during plating, and hydroxides are added to raise or maintain the pH. If the pH needs to be lowered, an acidic compound would be used as a pH adjusting ion. When formaldehyde is the reducing agent, the activity of the reducing agent depends on the pH as well as the concentration of the reducing agent. Therefore, to lower the activity of the reducing agent and thus lower the intrinsic anodic reaction rate, as described herein below, either the concentration of the formaldehyde reducing agent or of the hydroxide compound (i.e., pH) may be lowered.

For formulations with formaldehyde type reducing agents, the pH is usually set between 9.5 and 14.

Suitable complexing agents for electroless plating solutions are well known to those skilled in the art. Among the complexing agents useful for electroless copper plating solutions are ethylenedinitrilotetraacetic acid (EDTA), hydroyethylethylenediaminetriacetic acid (HEDTA), diethylenetrinitrilopentaacetic acid (DTPA), nitrilotriacetic acid (NTA), triethanolamine, tetrakis(2-hydroxypropyl)ethylenediamine (THPED), pentahydroxypropyldiethylenetriamine, and tartaric acid and its salts (Rochelle salts).

Copper deposits without fissures, and plated through hole printed circuits capable of withstanding a thermal stess of 288°C for 10 seconds may be plated from solutions comprising these complexing agents or mixtures thereof by the method and procedures of this invention.

Many additives have been proposed for use in electroless copper plating solutions. The additives which have been proposed may be classified by function into different groups. Most additives have more than a single effect on the electroless copper plating solutions, so classification may be somewhat arbitrary. There is some overlap between the additive groups, and almost all the additives affect the rate of the oxidation of the reducing agent (the anodic reaction) or the reduction of the copper ion to metal (cathodic reaction).

One group of additives are surfactants or wetting agents to control surface tension. Anionic, nonionic, amphoteric or cationic surfactants may be used and their choice may vary depending on the operating temperature and the ionic strength of the electroless plating employed.

Preferably, the surfactant is used at solution temperatures and ionic strengths below its cloud point. Surfactants containing polyethyoxy groups or fluorinated surfactants are preferred,

A second group of additives are stabilizers which prevent the spontaneous decomposition of the plating solution and/or the formation of undesired copper deposits outside of, or extraneous to, the desired deposit, so-called "extraneous copper".

A third group of additives may be classified as ductility promoters and/or additives to retard hydrogen inclusion in the deposit.

Although electrolessly deposited copper has been known for many years to be inferior to electrolytically deposited copper in resistance to thermal stress, ductility and other physical properties, surprisingly it has been found that if electroless copper deposition solutions are formulated and controlled to have an intrinsic anodic reaction rate less than 110% of the intrinsic cathodic reaction rate, copper deposits with superior physical properties, including resistance to thermal stress, may be obtained.

While not wishing to be bound by theory, it is postulated that when the electroless plating solution is under cathodic control, copper crystals grow rapidly with defects or dislocations trapped within the crystals. The plating solution is under cathodic control when the intrinsic anodic plating rate is much greater than the intrinsic cathodic plating rate, i.e., the rate of the cathodic reaction controls the rate of the anodic reaction.

It is assumed, since the intrinsic anodic reaction is faster, that the slow step in the plating reaction is diffusion of copper ions on the surface being plated, and electrons are readily available for reducing the copper in the cathodic reaction. So the copper is rapidly incorporated into the crystal without time to reach the correct place for integration into the lattice. When, according to this invention, the plating reactions are under anodic control (the intrinsic cathodic reaction is greater than the intrinsic anodic reaction) electrons are less available and in the cathodic reaction the incorporation of copper atoms on the surface into a copper crystal proceeds in a more uniform manner. Uniform structure in the crystals, and smaller crystal structure provide improved physical properties including resistance to thermal stress.

In electrocrystallization, which is the science of depositing metal by electroplating, it is well understood that metal ions constantly are adsorbed on and desorbed from a metal in contact with a solution of its ions.

When the metal is in equilibrium with the solution of its ions, and no net deposition of metal is taking place, the rate of metal ions moving to and from the metal surface may be electrochemically measured as an exchange current density, $i_o$. The exchange current density varies with temperature and increases with any increase in the metal ion concentration in the solution, which also increases the concentration of adsorbed metal ions, called adions.

When a metal is in equilibrium with a solution containing complexed metal ion, the exchange current density and the equilibrium adion concentration will vary with the strength and lability of the ligand-metal ion bond.

Adions randomly migrate about the metal surface until they either move back into the solution or are incorporated into the metal crystal lattice. When adequate time is available for the random migration of adions, they are preferentially incorporated into the crystal lattice at lattice vacancies which occur at edges or steps in the metal lattice. These sites for incorporating adions into the lattice are often called kink sites.

When electrodeposition is taking place more metal ions move onto the metal surface than are moved back from the metal surface into the solution by the exchange current density. These adions are incorporated into the metal lattice and stay there forming the metal deposit.

The measured current, i, in an electrodeposition reaction is the current in the forward direction, $i_f$, of ions from the solution becoming adions, less the reverse current, $i_b$, the exchange current density of adions moving back into the solution.

A similar model applies to electroless metal deposition. In electroless metal deposition the measured current is supplied by the reducing agent, and the current density may be considered by Faraday's Law as proportional to the moles of reducing agent consumed per unit area per second.

According to the theory, in this invention the limiting factor for producing electrolessly formed copper deposits of high quality being capable of passing the thermal stress test is the average time needed for an adion to migrate to a low energy lattice site for incorporation into the lattice. This time decreases with a) the concentration of adions, b) the density of low energy kink sites, and c) the temperature. The time increases with a) the number of sites blocked, e.g., by contaminants, by the reducing agent or by additives, and b) the tightness of the metal complex. When the current density due to the reaction of the reducing agent is sufficiently high the time available for adions to migrate along the surface falls below the average time needed to reach a low energy lattice site, and some of the adions are incorporated into the deposit in other places forming dislocations or defects and thus stressed and defective crystals.

The maximum rate of deposition for low defect crystals is a function of the metal adion availability and the density of low energy kink sites on the surface, and thus the intrinsic rate of the cathodic reaction (reduction of metal ion and incorporation into the lattice). Thus, the corresponding oxidation reaction must be controlled to maintain a current density which is sufficiently low and permits the formation of low defect crystals. Measuring the intrinsic reaction rates for the two half reactions and establishing that the intrinsic anodic rate does not exceed the intrinsic cathodic rate, assures the formation of high quality copper deposits with low defects and thus capable of passing the thermal stress test.

The intrinsic rate ratio can be established, as already disclosed in commonly assigned EP-A-265901, by measuring the reaction rates for two half reactions in the neighborhood of the mixed potential, e.g., at +10 mV for the one and at -10 mV for the other half reaction; or by sweeping the potential on the one and the other side of the mixed potential and measuring the current. In one method of operating this invention, the intrinsic anodic reaction rate at the mixed potential is estimated from the current required to vary the potential on a working electrode which is electrolessly depositing copper. The potential between the working electrode and a reference electrode is varied in a potential ramp between $E_{mp}$ and ±30 mV from $E_{mp}$ by passing current between the working electrode and a counter electrode and simultaneously measuring the potential and the anodic current as the potential changes. Alternatively, if the counter electrode is at $E_{mp}$ and very much larger than the working electrode, it can also serve as a reference electrode since the current passed between it and the working electrode would be too small to shift the counter electrode potential.

The intrinsic anodic reaction rate at $E_{mp}$ may be determined from the slope of a current vs. voltage plot as it approaches $E_{mp}$.

Similarly, the intrinsic cathodic reaction rate may be determined from the slope of the current vs. voltage plot between -30 mV from $E_{mp}$ and $E_{mp}$.

When the intrinsic cathodic deposition rate is maintained greater than the intrinsic anodic deposition rate, or when the ratio of the intrinsic anodic deposition rate to the intrinsic cathodic deposition rate, $r'_a/r'_c$, is less than 1.1, preferably less than 1.05, and more preferably less than 1.0, it had been found that copper with superior physical properties is deposited. In order to maintain the desired ratio, it may be desirable to increase the rate of the intrinsic cathodic reaction, or to decrease the rate of the intrinsic anodic reaction.

Among the methods for increasing the rate of the intrinsic cathodic reaction are (1) raising the concentration of the cathodic constituent, i.e., the metal ion concentration; (2) adding a catalyst or a depolarizer to accelerate the cathodic reaction; (3) increasing the surface area available for the cathodic reaction (e.g., by reducing the contaminants or the stabilizer concentration and the surface area blocked by contaminants or stabilizer; this may be accomplished by diluting the solution with fresh solution or by carbon treatment of the solution to remove contaminants blocking the surface area available for the cathodic reaction).

When the metal ion concentration becomes too high, extraneous metal deposition in the bulk of the solution or outside the desired metal pattern may be observed. For many electroless copper plating solutions, this occurs at copper ion concentrations above the range of 0.08 to 0.12 moles per liter.

The ratio, $r_a/r_c$, also may be maintained less than 1.0 by decreasing the rate of the intrinsic anodic reaction by (1) decreasing the concentration of the anodic reactants (i.e., lower formaldehyde and/or lower pH); or (2) decreasing the concentration of anodic depolarizers such as heterocyclic aromatic nitrogen or sulfur compounds. If the concentration of the anodic reactants is lowered too much, the $E_{mp}$ of the solution may rise by 50 to 200 mV and the solution becomes passive, i.e., there is no electroless deposition. The solution will become active again at a higher temperature. It has been found that, to decrease the concentration of the anodic reactants, the product of the formaldehyde concentration and the square root of the hydroxide ion concentration, $(CH_2O)(OH)^{0.5}$, must be decreased. Although either the formaldehyde or the hydroxide concentration each may be decreased, held constant, or even increased, the product, $(CH_2O)(OH)^{0.5}$, must be decreased to lower the intrinsic anodic reaction rate.

For plating solutions operating above room temperature, the square root of the hydroxide ion concentration, $(OH^-)^{0.5}$, may be conveniently estimated using the room temperature (25°C) pH of the solutions. In the examples below, values are given for the expression $(CH_2O)(OH^-)^{0.5}$ using the pH of the respective solutions at room temperature. To illustrate the validity of this simplification in the table below values calculated with room temperature pH are compared with the values calculated from the pH at operating temperature (75°C) for first seven examples:

| Example # | $CH_2O$ (mol/l) | pH (25°C) | $(CH_2O)(OH^-)^{0.5}$ 25°C | $(CH_2O)(OH^-)^{0.5}$ 75°C |
|---|---|---|---|---|
| 1 | 0.07 | 11.8 | 0.0058 | 0.0062 |
| 1 | 0.02 | 11.5 | 0.0010 | 0.0013 |
| 2 | 0.07 | 11.7 | 0.0050 | 0.0055 |
| 2 | 0.03 | 11.5 | 0.0017 | 0.0020 |
| 3 | 0.05 | 11.55 | 0.0030 | 0.0033 |
| 4 | 0.08 | 11.9 | 0.0070 | 0.0080 |
| 5 | 0.067 | 11.7 | 0.0047 | 0.0053 |
| 6A | 0.049 | 11.6 | 0.0031 | 0.0035 |
| 6B | 0.048 | 11.75 | 0.0036 | 0.0040 |

| Example # | $CH_2O$ (mol/l) | pH (25°C) | $(CH_2O)(OH^-)^{0.5}$ 25°C | $(CH_2O)(OH^-)^{0.5}$ 75°C |
|---|---|---|---|---|
| 7A | 0.133 | 12.8 | 0.0333 | 0.0333 |
| 7B | 0.067 | 12.6 | 0.0133 | 0.0134 |

In the event, that bath contaminants cause reduction of deposition rate and inadequate copper quality due to temporary, localized passivation of the plating surface, the condition must be compensated for by increasing the plating current produced by the anodic half reaction, i.e., by increasing the pH and/or formaldehyde.

Since this will increase intrinsic anodic reaction rate, the copper concentration must be increased to bring the ratio of $r_a/r_c$ to the original value before the solution became contaminated, or a value below 1.1 and adequate for the resulting plating rate.

Measurement of the intrinsic rate of the partial reactions:

The ratio of the intrinsic rate of the partial anodic and cathodic reactions have been determined from measurements of current-potential relationship in a narrow potential range (e.g., from -30 mV to +30 mV from the mixed potential, $E_{mp}$). This relationship is used in two ways. Both methods give similar conclusions regarding conditions for producing high quality copper deposits.

In one method, the cathodic current, $i_c$, at the potential which is 10 mV negative with respect to the $E_{mp}$ (i.e.,the overpotential, Eta = -10 mV vs. $E_{mp}$) is taken as the rate of the cathodic partial reaction, $(r_c)_{-10mV}$, or simplified $r_c$; the anodic current, $i_a$, at the potential which is 10 mV positive with respect to the $E_{mp}$ (i.e.,the overpotential, Eta = +10 mV vs. $E_{mp}$) is taken as the rate of the anodic partial reaction, $(r_a)_{+10mV}$, or simplified $r_a$.

Alternatively, in a computerized method, the intrinsic rates of the partial reactions are determined using the rate expression

$$r' = \sum_{j=1}^{n} (i_j E_j) / \sum_{j=1}^{n} ((E_j)^2)$$

where r' is the partial rate, $i_j$ is the current density at an overpotential, $\eta_j$ (Eta), referenced to the mixed potential, $E_{mp}$, and $E_j$ is calculated from the overpotential vs. $E_{mp}$, $\eta_j$(Eta), according to the equation

$$E_j = 10^{(\eta_j/b_a)} - 10^{(-\eta_j/b_c)}$$

where $b_a$ and $b_c$ are the Tafel slopes. For an electrochemical reaction, a plot of the overpotential, $\eta$, from the thermodynamic equilibrium potential vs. logarithm of the current, log i, was found by Tafel to be of the form

$\eta = a - b(\log i)$

For many electroless solutions, the anodic reaction,

$CH_2O + 2OH^- = HCOO^- + H_2O + 1/2H_2 + e^-$

the constant $b_a$ has the value 940 mV/decade, and for the cathodic reaction,

$CuL^{n+2} + 2e^- = Cu^o + L^n$

$b_c$ has the value 310 mV/decade.

The rate of the cathodic partial reaction, $r_c'$, is obtained, in this invention, by applying the above equation to a set of pairs of experimental values $(i_j, E_j)$ from the cathodic potential range which is, e.g., from -30 mV vs. $E_{mp}$ to $E_{mp}$. The rate of the partial anodic reaction, $r_a'$, is obtained by applying the above equation to a set of pairs of experimental values obtained from the anodic potential range which is, e.g., from $E_{mp}$ to E = +30 mV vs. $E_{mp}$.

The currents used to calculate intrinsic reaction rates are measured at potential near $E_{mp}$, e.g., 10 to 50 mV from $E_{mp}$, which may introduce some errors in the determination of the intrinsic reaction rates. The equations strictly apply only close to the mixed potential. If one examines both positive and negative overpotentials and currents for a particular solution, one will find near the mixed potential, the overpotential departs from the Tafel (semilogarithmic) relationship. The current measurements for determination of the intrinsic anodic and cathodic reaction rates must be in the range where the semi-logarithmic relationship is non-linear. This range is often within ±40 mV of the $E_{mp}$, but can be larger or smaller depending on the

9

electroless plating solution formulation. The admissable error depends on the set point of the ratio of the intrinsic anodic and cathodic reaction rates and thus on the formulation of the electroless plating solution.

Procedure:

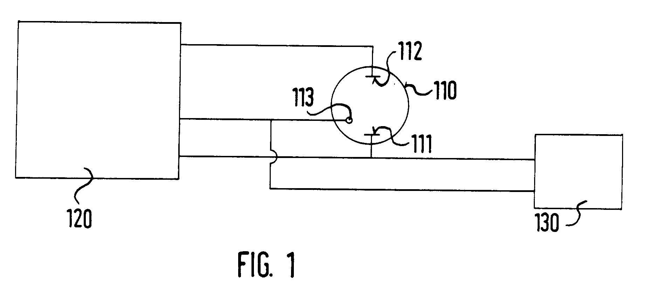

An experimental set-up for carrying out electrochemical measurements of $r_a$, $r_a'$, $r_c$ and $r_c'$, according to the invention, is shown in Fig. 1. and is composed of an electrochemical cell (110), a potentiostat with function generator (120) and a recorder (130).

In a typical test, an all-glass single compartment cell with three electrodes was used. The test electrode (111) was a platinum wire, 3.8 mm² in area (length 2.0 mm, diameter 0.6 mm), and the auxiliary electrode (112) a platinum cylinder (about 10 mm² in area), both electroplated with copper.

Plating was done in an acid copper solution ($CuSO_4.5H_2O$ - 188 g/l; $H_2SO_4$ - 74 g/l) at 10 mA/cm² for 1 to 5 min.

A saturated calomel electrode (SCE) (113) was used as a reference electrode.

The current-potential curves were obtained with an IBM Instruments Inc. EC7225 Voltammetric Analyzer [tm] (120) and recorded on an IBM Instruments Inc. 7424 X-Y-T Recorder [tm] (130).

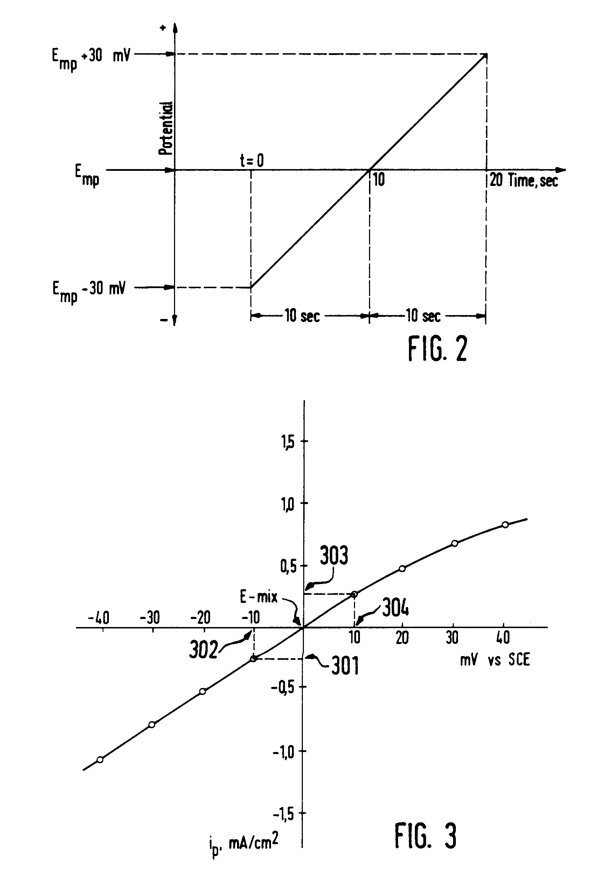

The test electrode (111), an auxiliary electrode (112) and a reference electrode (113) are connected to the potentiostat (120), which, with a function generator, was used in a DC operating mode for linear sweep voltammetry (LSV). The sweep waveform, as shown in Fig. 2, is a linear ramp; the current is continuously sampled; when the potential reaches a final value it is left at this value for a short period of time and then reset to the initial value, or an automatic scan reversal to the initial value can be used.

## EXAMPLE 1

Fully additive printed circuit boards were produced by electrolessly plating copper on adhesive coated, glass reinforced, epoxy laminates. Copper conductors deposited in the conductive pattern and on the walls of the plated through holes were 35 $\mu$m thick. The plating solution used had the following formulation:

| | |
|---|---|
| Copper sulfate | 0.028 moles/l |
| Ethylenedinitrilotetraacetic acid (EDTA) | 0.079 moles/l |
| Sodium sulfate (for adjusting specific gravity) | 0.500 moles/l |
| Formaldehyde | 0.070 moles/l |
| pH (at 25°C) | 11.8 |
| $(CH_2O)(OH^-)^{0.5}$ | 0.006 $(m/l)^{1.5}$ |
| Surfactant (nonylphenylpolyethoxyphosphate) | 0.040 g/l |
| Sodium cyanide | -150 mV vs. SCE |
| Specific gravity (at 25°C) | 1.082 |
| Operating temperature | 75°C |

The printed wiring boards plated in this solution were tested for thermal stress resistance according to MIL P-55110-D at 288°C for 10 seconds using molten solder.

After the test, cracks were found between the copper surface conductors and the copper hole walls.

The electroless copper plating solution was tested to determine the polarization data in the vicinity of +40 mV to -40 mV with reference to mixed potential, $E_{mp}$.

Fig. 2 shows the potential ramp of the test electrode vs. the reference electrode from -40 mV as a function of time.

Fig. 3 shows a current-potential graph of this test. As the applied potential on the test electrode is increased from -40 mV (with reference to the $E_{mp}$) to 0 (at $E_{mp}$), the auxiliary electrode (112) was anodic with respect to the test electrode (111) and a cathodic current was recorded on the test electrode. As the applied voltage approached $E_{mp}$, the current dropped to zero. As the applied potential became positive, the auxiliary electrode became cathodic with respect to the test electrode, and the anodic current on the test electrode starting from zero at $E_{mp}$ increased.

For electrolessly depositing high quality copper according to this invention, the plating reaction must be under anodic control. That means intrinsic anodic reaction rate is no more than 10% greater than, and preferably less than, the intrinsic cathodic reaction rate, or the ratio of the intrinsic anodic reaction rate to the intrinsic cathodic reaction rate is less than 1.1. In a first test of the criterion of anodic control, the ratio of the anodic current at 10 mV above $E_{mp}$ and the cathodic current at 10 mV below $E_{mp}$ was taken as an approximation of the ratio of the intrinsic anodic and cathodic reaction rates.

Referring to Fig. 3, at the potential (302), which is 10 mV negative with respect to $E_{mp}$, the cathodic current $i_c$ (301) was taken as the rate of the cathodic partial reaction, $r_c$. At the potential (304), which is 10 mV positive with respect to $E_{mp}$, the anodic current $i_a$(303) was taken as the rate of the anodic partial reaction, $r_a$.

Since the copper deposited by an electroless plating reaction is equivalent to a deposition current of 1 to 3 mA/cm$^2$, the current $r_c$ is actually the change in the deposition current produced by an overpotential of -10 mV, and $r_a$ is the change due to an overpotential of +10 mV.

The measured values of $r_a$ at +10 mV vs. $E_{mp}$ and $r_c$ at -10 mV vs. $E_{mp}$ were:

$r_a$ = 0.40 mA/cm$^2$; $r_c$ = 0.37 mV/cm$^2$

Therefore: Ratio = $r_a/r_c$ = 0.40/0.37 = 1.08

The ratio was greater than 1.05, but less than 1.10, by this test.

In order to confirm the relationship of the ratio to the tendency of the copper deposits to form cracks in the holes in the 288°C thermal stress test, a second, more precise analysis was performed on the electrochemical data.

In the second method, the rate of the partial reactions was determined using the rate expression

$$r' = \sum_{j=1}^{n} E_j i_j / \sum_{j=1}^{n} ((E_j)^2)$$

where r' is the rate in mA/mm$^2$,

$$E_j = 10^{(\eta_j/b_a)} - 10^{(-\eta_j/b_c)}$$

and $b_a$ was 940 mV/decade and $b_c$ was 310 mV/decade.

The anodic rate $r_a'$, and the cathodic rate, $r_c'$, were calculated using the above equation in the region of -40 mV to +40 mV with respect to $E_{mp}$.

The data from the electrochemical measurement were:

| Overpotential (mV) | Current i (mA/cm²) |
|---|---|
| 10 | 0.40 |
| 20 | 0.72 |
| 30 | 1.01 |
| 40 | 1.28 |
| -10 | -0.37 |
| -20 | -0.72 |
| -30 | -1.03 |
| -40 | -1.36 |

$(E_j i_j)_a$ = 1.115    $(E_j)_a^2$ = 0.349
$(E_j i_j)_c$ = 0.913    $(E_j)_c^2$ = 0.25
$r_a'$ = 3.65 mA/cm$^2$    $r_c'$ = 3.19 mA/cm$^2$
Ratio' = 3.65/3.19 = 1.14

This precise calculation of the ratio' showed that the copper deposited from a solution with a ratio' greater than 1.10 and, therefore, not under anodic control.

Such copper would fail the thermal stress test.

The formulation of the plating solution was modified according to the principles of this invention in order

11

to produce a copper plating solution operating under anodic control and a copper deposit which would pass the thermal stress test.

The concentration of the anodic reactant, the reducing agent, was lowered by lowering the product $(HCHO)(OH^-)^{0.5}$.

The formaldehyde concentration was reduced by almost 60% while the pH, and thus the hydroxide concentration, was decreased. The additive, sodium cyanide, concentration was reduced by over 85% (50 mV as measured by the specific ion electrode). The revised formulation was:

| | |
|---|---|
| Copper sulfate | 0.028 moles/l |
| EDTA | 0.079 moles/l |
| Sodium sulfate | 0.61 moles/l |
| Formaldehyde | 0.02 moles/l |
| pH (at 25°C) | 11.5 |
| $(CH_2O)(OH^-)^{0.5}$ | 0.001 $(m/l)^{1.5}$ |
| Surfactant | 0.04 g/l |
| Sodium cyanide (by specific ion electrode) | -100 mV vs. SCE |
| Specific gravity (at 25°C) | 1.098 |
| Temperature | 75°C |

The modified formulation reduced the ratio, $r_a/r_c$, below 1.0, and provided copper deposits that passed the thermal stress test. The electrochemical analysis of the intrinsic anodic and cathodic reaction rates was performed as described above. The results were:

$r_a$ = 0.27 mA/cm$^2$;　$r_c$ = 0.28 mA/cm$^2$

Ratio = $r_a/r_c$ = 0.96;

and

$r_a'$ = 2.44 mA/cm$^2$;　$r_c'$ = 2.46 mA/cm$^2$

Ratio' = $r_a'/r_c'$ = 0.99.

These electrochemical tests also showed that copper deposited from the revised formulation would pass the thermal stress test.

Fully additive printed wiring boards were plated in the electroless copper solution, and after testing with molten solder at 288°C for 10 seconds there were no cracks in the walls of the plated-through holes or at the junction between the walls of the holes and the surface conductive patterns.

In this example, additive printed circuit boards were prepared using an electroless copper plating solution which failed one and was marginal on one of the test methods taught by this invention. These additive printed circuit boards failed the thermal stress test of 10 seconds exposure to molten solder at 288°C. The plating solution was found to have a ratio $r_a'/r_c'$ greater than 1.1. When the solution was modified so that the ratio $r_a'/r_c'$ was less than 1.0 according to the teachings of this invention, it produced additive printed circuit boards that passed the thermal stress test.

EXAMPLE 2

An electroless copper plating solution was formulated as in Example 1, except that instead of adjusting the specific gravity by putting sodium sulfate in the formulation to simulate the high specific gravity of a continuous operating solution, the plating reaction was run for about 10 turnovers to develop the specific gravity of a normal production bath. A turnover is defined as one replacement of the copper ion content of the plating solution, i.e., for 10 turnovers of a plating solution containing 0.028 moles/l of copper ion, 0.28 moles/l or 18 g/l of copper metal is plated out; and 0.28 moles/l of copper salt and the required amounts of formaldehyde and sodium hydroxide have been added to the solution to maintain it. The high specific gravity of the solution is due to the reaction byproducts, sodium sulfate and sodium formate. The formulation was as follows:

| Copper sulfate | 0.028 moles/l |
|---|---|
| EDTA | 0.079 moles/l |
| Formaldehyde | 0.07 moles/l |
| Surfactant to maintain surface tension | 45 dynes/cm$^2$ |
| Sodium cyanide | -135 mV vs. SCE |
| pH (at 25°C) | 11.7 |
| Specific gravity (at 25°C) | 1.090 |
| Operating temperature | 75,0°C |

Fully additive printed wiring boards plated in this solution exhibited a few cracked hole walls after the thermal stress test. Electrochemical analysis of this bath yielded the data as shown below:

$r_a$ = 0.30 mA/cm$^2$;   $r_c$ = 0.28 mA/cm$^2$

Ratio = 0.30/0.28 = 1.07

$r_a'$ = 2.92 mA/cm$^2$;   $r_c'$ = 2.54 mA/cm$^2$

Ratio' = 2.92/2.54 = 1.15

As had been expected, the ratio', since it was greater than 1.1, indicated this solution would produce printed wiring boards that would fail the thermal stress test.

The less precise ratio, since it was greater than 1.05, suggested the copper deposits might not be strong enough to pass the thermal stress test.

In order to improve the resistance to fissures of the deposited copper and to provide copper plated printed wiring boards that would pass the thermal stress test, the formulation was modified. The anodic reaction rate was lowered by decreasing the formaldehyde from 0.07 to 0.03 moles/l, and the pH from 11.7 to 11.5 so that the product, $(HCHO)(OH^-)^{0.5}$, was dropped from 0.0047 to 0.0016. To maintain plating at lower reducing agent concentration, the stabilizer additive, sodium cyanide, was reduced to a concentration equivalent to -100 mV vs. SCE at 25°C. Electrochemical analysis was performed as described in Example 1 with the following results:

$r_a$ = 0.13 mA/cm$^2$;   $r_c$ = 0.17 mA/cm$^2$

Ratio = 0.13/0.17 = 0.76

$r_a'$ = 1.36 mA/cm$^2$;   $r_c'$ = 1.86 mA/cm$^2$

Ratio' = 1.36/1.86 = 0.73

As predicted by the ratio rests (i.e., ratios less than 1) printed wiring boards plated with copper in the modified solution passed the thermal stress tests.

EXAMPLE 3

An electroless copper plating bath was prepared with a stabilizer system using both vanadium and cyanide addition agents. The copper content of the solution was turned over until specific gravity reached 1.09. The formulation was as follows:

| Copper sulfate | 0.028 moles/l |
|---|---|
| EDTA | 0.075 moles/l |
| Formaldehyde | 0.050 moles/l |
| pH (at 25°C) | 11.55 |
| $(HCHO)(OH^-)^{0.5}$ | 0.0030 |
| Surfactant | 0.04 g/l |
| Vanadium pentoxide | 0.0015 g/l |
| Sodium cyanide | -105 mV vs. SCE |
| Specific gravity (at 25°C) | 1.090 |
| Operating temperature | 75°C |

Electrochemical analysis of the solution as described in Example 1 gave the following results:

$r_a$ = 0.26 mA/cm$^2$ ;   $r_c$ = 0.33 mA/cm$^2$

Ratio = 0.79

$r_a'$ = 2.56 mA/cm$^2$ ;   $r_c'$ = 2.80 mA/cm$^2$

Ratio' = 0.89

This solution was used to electrolessly deposit copper on 1.5 mm thick, adhesive coated, epoxy glass laminates to make fully additive printed wiring boards. The printed wiring boards passed the thermal stress test at 288°C for 10 s.

The results from the thermal stress test confirm the electrochemical tests. Both the thermal stress test and the electrochemical analysis indicate a high quality, tough copper deposit.

EXAMPLE 4

An electroless copper plating solution was prepared with a high copper concentration and a correspondingly high specific gravity. The formulation was as follows:

| | |
|---|---|
| Copper sulfate | 0.12 moles/l |
| EDTA | 0.20 moles/l |
| Formaldehyde | 0.08 moles/l |
| pH(25°C) | 11.9 |
| $(CH_2O)(OH^-)^{0.5}$ | $0.007(moles/l)^{1.5}$ |
| Cyanide (Orion electrode) | -110 mV vs. SCE |
| Vanadium pentoxide | 5.0 mg/l |
| Specific gravity | 1.124 |
| Operating temperature | 75°C |
| $r_a$ | 0.14 mA/cm$^2$ |
| $r_c$ | 0.16 mA/cm$^2$ |
| Ratio $r_a/r_c$ | 0.88 |
| $r_a'$ | 1.13 mA/cm$^2$ |
| $r_c'$ | 1.96 mA/cm$^2$ |
| Ratio' $r_a'/r_c'$ | 0.58 |

Additive printed circuit boards were plated in this solution and after plating tested by the thermal stress test at 288°C for 10 s. There were no cracks formed in the copper by the thermal stress test which confirmed the results from the ratio of the intrinsic anodic and cathodic reaction rates.

EXAMPLE 5

A vanadium stabilizer system was tested in a solution taken from a working, production electroless copper plating solution. This solution contained the byproducts sodium formate and sodium sulfate produced by the copper turnovers as the solution was used. The formulation was as follows:

| | |
|---|---|
| Copper sulfate | 0.028 moles/l |
| EDTA | 0.076 moles/l |
| Formaldehyde | 0.067 moles/l |
| pH (25°C) | 11.7 |
| Surfactant | 0.04 g/l |
| Vanadium pentoxide | 0.003 g/l |
| Specific gravity (at 25°C) | 1.082 |
| Operating temperature | 75°C |

Fully additive printed wiring boards were plated in this solution to a copper thickness of 35 $\mu$m. The printed wiring boards were subjected to the thermal stress test at 288°C for 10 s. Over 60% of the plated-through holes developed breaks separating the copper hole walls from the copper surface conductors. Electrochemical analysis was performed as described in Example 1 yielding the kinetic data shown below:

$r_a$ = 0.34 mA/cm$^2$ ;   $r_c$ = 0.31 mA/cm$^2$

Ratio = 0.34/0.31 = 1.1

Since the ratio was greater than 1.0, the holes were expected to crack. The more precise ratio' test had the following results:

$r_a' = 4.01 \text{ mA/cm}^2$ ; $r_c' = 2.65 \text{ mA/cm}^2$
Ratio' = 4.01/2.65 = 1.5

Since this ratio' test gave a result very much greater than 1.0, the high percentage of failures in the thermal stress test was to be expected in the light of the teaching of this invention.

EXAMPLE 6

A solution from another working production, electroless copper plating bath was adjusted to the formulation of Example 3 as far as its formulated bath constituents are concerned. Although the formulation was the same as the successful Example 3 solution, electrochemical analysis of the solution gave a ratio of 1.1 and a ratio' of 1.05, indicating borderline performance. The deviation of the electrochemical ratio results from the good ratio results obtained in Example 3 indicate the presence of an unknown contaminate. Fully additive printed wiring boards were prepared on adhesive coated, epoxy glass laminates in this electroless copper plating solution bath. Thermal stress testing showed cracks in 20% of the copper hole walls. The solution was modified by reducing the vana - dium stabilizer in order to get electrochemical ratios less than 1.0. The formulations of the two bath solutions are shown below:

|  | A | B |
| --- | --- | --- |
| Copper sulfate | 0.028 | 0.028 moles/l |
| EDTA | 0.076 | 0.076 moles/l |
| Formaldehyde | 0.049 | 0.048 moles/l |
| pH (at 25 ° C) | 11.6 | 11.75 |
| $(HCHO)(OH^-)^{0.5}$ | 0.0031 | $0.0036 (\text{moles/l})^{1.5}$ |
| Sodium cyanide | -110 | -110 mV vs. SCE |
| Vanadium pentoxide | 0.0012 | 0.0008 g/l |
| Specific gravity (at 25 ° C) | 1.094 | 1.094 g/ml |
| Operating temperature | 75 | 75 ° C |
| $r_a$ | 0.33 | 0.30 mA/cm$^2$ |
| $r_c$ | 0.30 | 0.33 mA/cm$^2$ |
| Ratio | 1.10 | 0.91 |
| $r_a'$ | 2.87 | 2.75 mA/cm$^2$ |
| $r_c'$ | 2.74 | 2.93 mA/cm$^2$ |
| Ratio' | 1.05 | 0.94 |
| Thermal stress | 20% | 0.0% cracks |

This Example demonstrates the utility of the ratio of the electrochemical analysis of the intrinsic anodic and cathodic reaction rates to adjust an operating plating bath solution and compensate for contamination.

EXAMPLE 7

A solution was prepared similar to Exampler 6, with the following formulation:

| | |
|---|---|
| Copper sulfate | 0.056 moles/l |
| EDTA | 0.110 moles/l |
| Formaldehyde | 0.047 moles/l |
| pH (at 25°C) | 11.9 |
| $(CH_2O)(OH^-)^{0.5}$ | 0.0042 $(moles/l)^{1.5}$ |
| Sodium cyanide (Orion electrode) | -100 mV vs. SCE |
| Specific gravity (at 25°C) | 1.066 |
| Temperature | 75°C |
| $r_a$ | 0.33 mA/cm$^2$ |
| $r_c$ | 0.40 mA/cm$^2$ |
| Ratio | 0.83 |
| $r_a'$ | 1.69 mA/cm$^2$ |
| $r_c'$ | 1.98 mA/cm$^2$ |
| Ratio' | 0.85 |
| Thermal stress test | no cracks |

Because the solution was under anodic control, the increase of the copper ion concentration to twice the concentration of Example 6 did not cause a corresponding increase in the plating rate. The copper metal was deposited at approximately the same rate as the solutions of Example 6, and it required 17 h to deposit 35 $\mu$m thick copper layer.

In order to accelerate the plating rate, since the concentration of the cathodic reactant had already been doubled over Example 6, the concentration of the anodic reactants was increased. The changes in the formulation are shown below:

| | |
|---|---|
| pH (at 25°C) | 12.2 |
| $(CH_2O)(OH^-)^{0.5}$ | 0.006 $(moles/l)^{1.5}$ |
| Sodium cyanide | -110 mV vs. SCE |
| Specific gravity (at 25°C) | 1.070 |
| $r_a$ | 0.47 mA/cm$^2$ |
| $r_c$ | 0.49 mA/cm$^2$ |
| Ratio | 0.96 |
| $r_a'$ | 5.02 mA/cm$^2$ |
| $r_c'$ | 5.30 mA/cm$^2$ |
| Ratio' | 0.95 |
| Thermal stress test | no cracks |

This solution deposited 35 $\mu$m copper in less than 8 h. This example illustrates how the principles of this invention may be used to obtain copper with superior physical properties at fast plating rates.

EXAMPLE 8

An electroless copper plating bath solution was formulated using a polyethylene glycol and 2,2'-dipyridyl as the stabilizer. The modified formulation was:

| | |
|---|---|
| Copper sulfate pentahydrate | 12 g/l |
| EDTA | 32 g/l |
| Formaldehyde | 3.2 g/l |
| pH (at 25°C) | 12.0 |
| Polyethylene glycol (M.W. = 600) | 10 g/l |
| 2,2'-dipyridyl | 30 mg/l |
| Operating temperature | 75°C |

Electrochemical analysis of the intrinsic anodic and cathodic reaction rates of this solution by the methods described in Example 1 yielded the following results:

$r_a$ = 0.28 mA/cm$^2$ ;   $r_c$ = 0.30 mA/cm$^2$

16

Ratio = 0.28/0.30 = 0.93
and
$r_a$' = 2.97 mA/cm$^2$ ; $r_c$' = 3.18 mA/cm$^2$
Ratio' = 2.97/3.18 = 0.93

Since the results of both the electrochemical ratio tests are less than 1.0, the tests indicate the copper deposited by this solution would pass the 288°C thermal stress test.

These test results were confirmed by electrolessly plating a printed wiring pattern on an epoxy glass laminate in the solution. After plating the laminate was treated by the standard procedure, 1 h at 160°C, and thermal stress tested at 288°C for 10 s. No cracks were formed in the copper conductors or the plated through holes.

EXAMPLE 9

In another formulation a different polyethylene glycol was used as a stabilizer along with 2,2'-dipyridyl and sodium cyanide. The modified formulation was as follows:

| | |
|---|---|
| Copper sulfate pentahydrate | 10 g/l |
| EDTA | 45 g/l |
| Formaldehyde | 4 ml/l |
| Polyethylene glycol (M.W- = 1900) | 20 g/l |
| 2,2'-dipyridyl | 30 mg/l |
| Sodium cyanide | 1 mg/l |
| pH (at 25°C) | 12.4 |
| Operating temperature | 75.0°C |

Anodic and cathodic electrochemical analyses were performed on the solution by the methods described in Example 1. The data from the electrochemical tests yielded the following results:
$r_a$ = 0.15 mA/cm$^2$ ; $r_c$ = 0.16 mA/cm$^2$
Ratio = 0.94
$r_a$' = 1.66 mA/cm$^2$ ; $r_c$' = 1.72 mA/cm$^2$
Ratio' = 0.97

These data indicated the copper deposited from the solution would be fissure free. Printed wiring boards plated in the solution were thermally stressed by floating them on molten solder at 288°C for 10 s. No cracks or fissures developed in the copper conductors or plated through holes.

EXAMPLE 10

In this example, a test solution was deliberately contaminated to show how the teaching of this invention may be used to adjust the formulation, or reset the control parameters, to obtain fissure free copper deposits from a solution in which contaminants have built up over a period of time as the solution is used.

The electroless copper test bath solution was similar to the solution of Example 3. In the table below, this solution is marked "A". The electrochemical analysis of the solution gave a ratio of the intrinsic anodic reaction rate to the intrinsic cathodic reaction rate, ratio' = $r_a$'/$r_c$' of less than 1.1 indicating the solution would deposit high quality, fissure free copper.

As a deliberate contaminant, 1 mg/l of 2-mercaptobenzothiazole (2-MBT) was added to the test solution. The addition of the contaminant turned the solution passive, i.e., stopped the electroless plating reaction, and the mixed potential of the copper electrode in the test solution was shifted outside the electroless plating range. In the table below, this is solution "B". The electrochemical analysis showed the ratio' at this new mixed potential was greater than 1.1.

In order to regain a mixed potential for electroless copper plating, the formaldehyde concentration was tripled. Even at this higher formaldehyde concentration the solution was almost passive, depositing copper at an extremely slow rate, less than 0.04 $\mu$m/h. The solution is listed in the table below as solution "C".

The ratio of the intrinsic anodic reaction rate to the intrinsic cathodic reaction rate, ratio', was greater than 1.1, indicating that even if a solution at such a slow plating rate would deposit 25 $\mu$m copper, the deposit would fissure and fail a thermal stress test.

To increase the rate of copper deposition, the test solution was further modified by increasing the pH. The modified formulation is listed in the table as solution "D". While the deposition rate was increased, as expected, the electrochemical analysis of the intrinsic anodic reaction rate and the intrinsic cathodic reaction rate gave a ratio' greater than 1.1 indicating the copper deposits would be subject to fissures.

Following the teaching of this invention, the copper concentration of the formulation was increased to increase the intrinsic cathodic reaction rate relative to the intrinsic anodic reaction rate. However, this solution, listed in the table as solution "E", still had a ratio' of the intrinsic anodic reaction rate to the intrinsic cathodic reaction rate greater than 1.1.

To lower the intrinsic anodic reaction rate relative to the intrinsic cathodic reaction rate, the solution was reformulated with a lower formaldehyde concentration; this is solution "F". The ratio' was reduced to less than 1.1, so the solution would deposit high quality copper.

To achieve a preferred ratio' of the intrinsic anodic reaction rate to the intrinsic cathodic reaction rate, the concentration of the anodic reactant, formaldehyde, was further reduced. The formulation is listed as solution "G" in the table. The ratio' of the intrinsic anodic reaction rate to the intrinsic cathodic reaction rate for this solution is less than 1.0, and thus the solution can provide a high quality, fissure free copper deposit.

EXAMPLE 11

The procedure of Example 10 was repeated using a plating tank for 70 liters of the solution. The plating tank was equipped with an electroless copper plating bath controller which continuously measured the solution parameters such as the copper and formaldehyde concentrations, the pH, the cyanide ion activity and the temperature. The plating bath controller automatically compared the measured parameters to the set points and made additions to the solution to maintain it within the preset operating limits.

The plating solution was prepared similar to that of Example 3. The solution was operated to deposit approximately 6 turnovers. (A turnover is replacing the copper salt content of the solution once). This raised the specific gravity of the solution due to the formation of byproduct sodium sulfate and sodium formate. The intrinsic anodic and cathodic reaction rates were measured by electrochemical analysis, and the ratio' of the intrinsic anodic reaction rate to the intrinsic cathodic reaction rate was less than 1.1 which indicates the copper deposit is resistant to the thermal stress test.

The solution was used to make additive printed circuit

18

TABLE

| Solution | | A | B | C | D | E | E | G |
|---|---|---|---|---|---|---|---|---|
| $CuSO_4$ | mol/l | 0.028 | 0.028 | 0.028 | 0.028 | 0.056 | 0.056 | 0.056 |
| EDTA | mol/l | 0.101 | 0.101 | 0.101 | 0.101 | 0.157 | 0.157 | 0.157 |
| $CH_2O$ | mol/l | 0.040 | 0.040 | 0.133 | 0.133 | 0.133 | 0.040 | 0.027 |
| pH | 25°C | 11.5 | 11.5 | 11.5 | 12.5 | 12.5 | 12.5 | 12.5 |
| $(CH_2O)(OH^-)^{0.5}$ | $(ml/l)^{1.5}$ | 0.002 | 0.002 | 0.007 | 0.024 | 0.024 | 0.007 | 0.005 |
| Surfactant (GAFAG RE610) | mg/l | 40.0 | 40.0 | 40.0 | 40.0 | 40.0 | 40.0 | 40.0 |
| $V_2O_5$ | mg/l | 1.0 | 1.0 | 1.0 | 1.0 | 1.0 | 1.0 | 1.0 |
| NaCN | mg/l | 20.0 | 20.0 | 20.0 | 20.0 | 20.0 | 20.0 | 20.0 |
| 2-MBT | mg/l | 0 | 1.0 | 1.0 | 1.0 | 1.0 | 1.0 | 1.0 |
| Operating Temperature | °C | 75 | 75 | 75 | 75 | 75 | 75 | 75 |
| $E_{mp}$ vs. SCE | mV | -749 | -406 | -490 | -820 | -845 | -810 | -786 |
| $r_a'$ | mA/cm² | 1.41 | 0.027 | 0.036 | 3.25 | 5.12 | 3.50 | 2.65 |
| $r_c'$ | mA/cm² | 1.49 | 0.019 | 0.028 | 2.90 | 4.46 | 3.32 | 2.79 |
| Ratio' ($r_a'/r_c'$) | | 0.9 | 1.5 | 1.29 | 1.12 | 1.15 | 1.05 | 0.95 |
| Plating rate | µm/h | 1.7 | 0.02 | 0.03 | 3.6 | 5.6 | 4.0 | 3.3 |

boards by the electroless deposition of copper to form surface conductors and plated through holes. The printed circuit boards were thermally stressed by contact with molten solder at 288°C for 10 s. Thereafter, the plated through holes were microsectioned and examined for cracks and fissures in the deposited copper. There was, however, no evidence of such cracks or fissures. The formulation tested is shown in the table below.

19

The operating solution, found to deposit fissure free copper, was then treated with 0.5 mg of 2-mercaptobenzothiazole (2-MBT) as a deliberate contaminant to simulate the effect of contamination of the plating solution by organic compounds. Organic contamination is a frequent problem in electroless copper plating, especially in solutions operated for five or more turnovers. Sources of contamination include leaching from plastic substrates being electrolessly plated, from the plating resist or from fortuitous contamination.

After the addition of the contaminant, the plating bath solution became substantially passive. The plating rate was about 0.03 μm per hour and the solution would no longer deposit copper on the hole walls of the insulated base material to make plated through holes. The ratio' of the intrinsic anodic and cathodic reaction rates was greater than 1.1, so even if copper would have been deposited on the hole walls, the formed deposit, and thus the plated through holes, would fail the thermal stress test. This solution is more fully described below.

Following the procedure of Example 11, in a sample of the solution, the pH was raised to provide a more active plating solution, and the copper concentration was increased to adjust the ratio' of the intrinsic anodic and cathodic reaction rates to less than 1.1. When a ratio' of less than 1.1 was achieved, the set in the electroless plating bath controller for copper concentration and pH were reset. Additive printed circuit boards were plated in the contaminated electroless plating solution using the new set points. The copper deposited on these printed circuit boards was tested by thermal stress with molten solder at 288°C for 10 s and was found to be free of cracks or fissures.

The formulation, set points and test data for this solution are given below.

| | | Original good Solution | Bad contaminated solution | Solution with reset controls |
|---|---|---|---|---|
| $CuSO_4$ | mol/l | 0.028 | 0.028 | 0.040 |
| EDTA | mol/l | 0.087 | 0.087 | 0.100 |
| $CH_2O$ | mol/l | 0.047 | 0.047 | 0.047 |
| pH | 25°C | 11.75 | 11.75 | 12.40 |
| $(CH_2O)(CH^-)^{0.5}$ | $(mol/l)^{1.5}$ | 0.003 | 0.003 | 0.007 |
| Surfactant (GAFAC RE-610) | mg/l | 40 | 40 | 40 |
| NaCN | mV | -130 | -130 | -130 |
| $V_2O_5$ | mg/l | 1.0 | 1.0 | 1.0 |
| Specific gravity | g/cm³ | 1.066 | 1.066 | 1.066 |
| Temperature | °C | 75 | 75 | 75 |
| $E_{mp}$ vs. SCE | mV | -764 | -553 | -687 |
| Plating Rate | μm/h | 1.7 | 0.03 | 2.9 |
| $r_a'$ | mA/cm² | 1.44 | 0.028 | 2.57 |
| $r_c'$ | mA/cm² | 1.39 | 0.022 | 2.40 |
| Ratio' $(r_a'/r_c')$ | | 1.04 | 1.26 | 0.93 |
| Thermal stress | | pass | fail | pass |

In this example, a passive contaminated solution was restored to active plating, and then by adjustment of the formulation in accordance with the teachings of this invention, the intrinsic anodic and intrinsic cathodic reation rates of the contaminated plating solution were adjusted to deposit high quality copper.

EXAMPLE 12

In this example, fissure resistant copper was deposited from an electroless copper deposition solution operating at low temperature. An electroless copper plating solution was formulated to operate at 30°C. The solution plated slowly, depositing 25 $\mu$m of copper in three days.

This first solution is given in the table below. As reported, the ratio of the intrinsic anodic to the intrinsic cathodic reaction rates is greater than 1.1, and the additive printed circuit boards prepared in the solution failed the thermal stress test.

Following the teachings of this invention, the concentration of the anodic reactants was reduced to lower the anodic reaction rate relative to the cathodic reaction rate, and obtain the 2nd solution in the table below:

| | | Solution 1st | Solution 2nd |
|---|---|---|---|
| $CuSO_4$ | mol/l | 0.028 | 0.028 |
| EDTA | " | 0.087 | 0.087 |
| Formaldehyde | " | 0.067 | 0.013 |
| pH | 25°C | 12.5 | 12.5 |
| $(CH_2O)(OH^-)^{0.5}$ | $(mol/l)^{1.5}$ | 0.012 | 0.002 |
| NaCN | mg/l | 20 | 20 |
| $V_2O_5$ | " | 3 | 3 |
| Temperature | °C | 30 | 30 |
| $E_{mp}$ vs. SCE | mV | -783 | -750 |
| $r_a'$ | mA/cm² | 0.341 | 0.323 |
| $r_c'$ | mA/cm² | 0.280 | 0.304 |
| Ratio' ($r_a'/r_c'$) | | 1.22 | 1.06 |

The second solution is used to plate additive printed circuit boards with 25 $\mu$m copper. It is difficult to initiate electroless plating on catalytic adhesive and catalytic base materials at low temperature and low formaldehyde concentration. Therefore, before plating the additive circuit boards, the conductive pattern including the plated through holes are covered with a thin layer of copper about 0.2 $\mu$m thick in an electroless strike solution which has a formaldehyde concentration of 0.13 moles/l. These additive printed circuit boards pass the thermal stress test.

EXAMPLE 13

Two electroless plating bath solutions were prepared as shown below using tetrakis(2-hydroxypropyl)-ethylenediamine as the complexing agent for the copper ion.

21

| | | | |
|---|---|---|---|
| Copper Sulfate | moles/l | 0.028 | 0.028 |
| Tetrakis(2-hydroxypropyl)-ethylenediamine | moles/l | 0.079 | 0.079 |
| Formaldehyde | moles/l | 0.027 | 0.027 |
| pH | 25°C | 12.5 | 12.5 |
| $(CH_2O)(OH^-)^{0.5}$ | $(m/l)^{1.5}$ | 0.005 | 0.005 |
| Sodium cyanide | mg/l | 40 | 40 |
| Vanadium pentoxide | mg/l | 2 | -- |
| 2,2'-dipyridyl | mg/l | -- | 50 |
| Surfactant (Pluronic P-85 $^{tm}$) | mg/l | -- | 10 |
| Operat. Temperature | °C | 61 | 50 |
| $E_{mp}$ vs. SCE | mV | -716 | -774 |
| $r_a'$ | mA/cm² | 2.84 | 2.38 |
| $r_c'$ | mA/cm² | 2.59 | 2.36 |
| Ratio' ($r_a'/r_c'$) | | 1.10 | 1.01 |
| Thermal stress | cracks | yes | no |

When the ratio of intrinsic anodic to intrinsic cathodic reaction rate was 1.1, the additive printed circuit boards produced in the electroless copper plating solution failed the thermal stress test. When the ratio was lower, namely 1.01, the additive printed circuit boards passed the thermal stress test.

EXAMPLE 14

An electroless copper plating solution was prepared with the following composition:

| | |
|---|---|
| Copper sulfate | 0.02 moles/l |
| Tetrakis(2-hydroxypropyl)ethylenediamine | 0.096 moles/l |
| Formaldehyde | 0.02 moles/l |
| pH (at 25°C) | 12.6 |
| Cyanide (Orion electrode) | -135 mV |
| 2,2'-dipyridyl | 80.0 mg/l |

This solution was operated at four different temperatures with the following results:

| | | | | | |
|---|---|---|---|---|---|
| Temperature | °C | 40 | 50 | 64 | 75 |
| Plating rate | µm/h | 1.5 | 2.3 | 3.6 | unstable |
| $E_{mp}$ vs. SCE | mV | -765 | -757 | -750 | -- |
| $r_a'$ | mA/cm² | 1.29 | 1.67 | 2.88 | -- |
| $r_c'$ | mA/cm² | 1.38 | 1.95 | 3.24 | -- |
| Ratio' | | 0.93 | 0.86 | 1.13 | -- |

This demonstrates that while increasing the temperature increases the plating rate as is well known in the art, contrary to the previous teachings for electroless copper plating, increasing the temperature can change the ratio of the intrinsic anodic and cathodic reaction rates, to a ratio indicative for unsatisfactory copper deposits, and thus produce copper deposits of minor quality and susceptible to fissure formation when thermal stress tested.

EXAMPLE 15

A gravimetric test procedure is used to select an electroless copper plating solution formulation that operates under anodic control and deposits copper resistant to fissures or cracks when thermally stressed. The rate of the electroless plating reaction is determined by weighing the milligrams of copper per hour electrolessly deposited on a catalytic surface immersed in the electroless plating solution. When the plating rate changes as a function of the concentration of the cathodic reactants, i.e., copper ion concentration, the solution is under cathodic control; if it changes as a function of the concentration of anodic reactants, i.e., formaldehyde or pH, the plating solution operates under anodic control.

A suitable test surface is a stainless steel plaque with a surface area of 10 or 20 $cm^2$. The plaque is cleaned and immersed in a dilute solution (e.g. 0.1 g/l) of palladium chloride to insure the surface is catalytic. The plaque is then immersed in an electroless copper deposition solution for a period sufficient to deposit 1 to 10 mg of copper on the surface. At the end of the period, the plaque now plated with copper is removed from the solution and rinsed and dried (e.g., at 105°C for 30 min). The plaque is weighed, the copper stripped from the plaque by immersion in nitric acid, and the plaque is rinsed, dried and reweighed to determine the weight of copper per hour deposited during the period of immersion in the deposition solution.

One liter test solutions are prepared with the following compositions:

| | | | |
|---|---|---|---|
| Copper sulfate | moles/l | 0.024 | 0.048 |
| EDTA | " | 0.100 | 0.124 |
| Formaldehyde | " | 0.267 | 0.267 |
| pH | at 25°C | 12.3 | 12.3 |
| $(CH_2O)(OH^-)^{0.5}$ | $(mol/l)^{1.5}$ | 0.038 | 0.038 |
| Vanadium pentoxide | mg/l | 0.5 | 0.5 |
| Operating temperature | °C | 30 | 30 |

Stainless steel plaques were prepared and immersed in the plating solutions. After one hour, the plaques were removed and the amount of copper electrolessly deposited on each plaque is determined gravimetrically as described above. The plating rate for the solution containing 0.048 moles/l copper ion is faster than for the solution containing 0.024 moles/l. This demonstrates that the plating rate of the solutions is controlled by the cathodic reaction, and copper deposited from these formulations will not pass the thermal stress test.

Two additional solutions are prepared having the same formulation except that the formaldehyde concentration is 0.133 moles/l instead of 0.267 moles/l. Plaques are also plated in these solutions, and the plating rate of each solution is determined as described above. The plating rate of the solution containing 0.048 moles/l copper ion is faster than the plating rate of the solution containing 0.024 moles/l copper ion. Thus, these solutions are also under cathodic control.

Two new solutions are prepared with the same concentrations of copper sulfate and formaldehyde in both solutions, but varying the pH. The compositions are:

| Copper sulfate | moles/l | 0.026 | 0.026 |
| EDTA | " | 0.100 | 0.100 |
| Formaldehyde | " | 0.067 | 0.067 |
| pH | at 25°C | 12.2 | 12.4 |
| $(CH_2O)(OH^-)^{0.5}$ | $(mol/l)^{1.5}$ | 0.008 | 0.011 |
| $V_2O_5$ | mg/l | 0.5 | 0.5 |
| Operating temp. | °C | 30 | 30 |

The plating solutions are gravimetrically tested as described above, and it is found that the plating rate increases as the pH increases, Thus, the solutions are under anodic control.

These two solutions are prepared in larger volumes having the same formulations as the two solutions under anodic control above. Adhesive coated epoxy glass base material provided with resist patterns and holes for through connections are electrolessly plated with copper in the two solutions to form additive printed circuit boards. After plating, the additive printed circuit boards will pass the thermal stress test.

EXAMPLE 16

A solution is prepared with the following composition:

| Copper chloride | 0.056 moles/l |
| EDTA | 0.112 moles/l |
| Sodium hydroxide (to pH at 25°C) | 12.4 |
| Sodium cyanide | 0.02 g/l |
| $V_2O_5$ | 0.003 g/l |

The solution is divided into five beakers, and the five beakers are heated to 75°C. A quantity of formaldehyde is added to each beaker. 0.01 moles/l formaldehyde is added to the first beaker, and 0.02, 0.04, 0.06 and 0.08 moles/l to each of the other beakers, respectively.

The plating rate in each beaker is determined gravimetrically by the procedure as described in Example 15. From the gravimetric measurements of the copper deposition rate it is determined that the plating rate levels off in the beakers containing 0.06 and 0.08 moles/l formaldehyde, i.e., the plating rate switches from anodic to cathodic control.

A plating solution is prepared containing 0.05 moles/l formaldehyde, and is used to deposit copper which, when used to make printed circuit boards, is capable of passing the thermal stress test.

**Claims**

1. A method for depositing copper which is essentially free of fissures on a substrate with an electroless copper deposition solution comprising copper ions, a pH-adjuster, a ligand for copper ions and a reducing agent for the copper ions, characterized in that the method comprises preparing said electroless copper deposition solution and operating the solution by adjusting the concentrations of anodic and cathodic reagents such that the ratio of its measured intrinsic anodic reaction rate to its measured intrinsic cathodic reaction rate is less than 1.1, whereby the anodic and cathodic reagents are bath constituents which participate in the anodic and the cathodic reaction, respectively, and influence the intrinsic cathodic reaction rate and the intrinsic anodic reaction rate, respectively; and depositing copper with said electroless deposition solution on said substrate.

2. The method of claim 1, wherein said reducing agent is formaldehyde in the presence of hydroxide ions.

3. A method of adjusting and/or operating an electroless copper deposition solution to ensure that it will deposit a copper deposit free of fissures on a substrate, said solution comprising copper, one or more ligands, formaldehyde, an alkali metal hydroxide, and one or more additives, said method comprising the steps of

a) measuring the intrinsic anodic reaction rate of said deposition solution;

b) measuring the intrinsic cathodic reaction rate of said solution; c) comparing the measured rates to determine whether the ratio of said intrinsic anodic reaction rate to said intrinsic cathodic reaction rate is less than 1.1; and

d) adjusting the intrinsic reaction rates so that said ratio is less than 1.1.

4. The method of Claim 3, wherein, after adjusting the ratio of the intrinsic reaction rates, steps b) and c) are repeated to determine whether said ratio is less than 1.1; and repeating step d) and steps b) and c) until the measured ratio is less than 1.1.

5. The method of Claim 4, wherein the ratio is adjusted by increasing the ratio of the intrinsic cathodic reaction rate relative to the intrinsic anodic reaction rate by increasing the copper concentration, by increasing the concentration of one or more of the additives and/or by decreasing the concentration of the formaldehyde and/or the alkali metal hydroxide.

6. A method of controlling the commercial operation of an electroless copper deposition solution comprising copper, one or more ligands, formaldehyde, an alkali metal hydroxide, and one or more additives, comprising the steps of

a) measuring the intrinsic anodic reaction rate and intrinsic cathodic reaction rate of said deposition solution;

b) comparing the measured rates to determine whether the ratio of the measured intrinsic cathodic reaction rate to the measured intrinsic anodic reaction rate is less than 1.1;

c) discontinuing commercial use of said deposition solution unless said ratio is less than 1.1.

7. The method of claim 6, further including the steps of

d) re-adjusting said intrinsic anodic reaction rate and/or said intrinsic cathodic reaction rate so that said ratio is returned to the original ratio of said solution or is less than 1.1; and

e) resuming commercial use of said deposition solution.

8. The method of claims 1, 3 and 6, wherein said ratio is less than 1.05, and preferably less than 1.0.

9. The method of claims 1, 3 and 6, wherein said ratio is maintained by increasing the intrinsic cathodic rate relative to the intrinsic anodic rate.

10. The method of claim 9, wherein said deposition solution contains one or more contaminants and wherein said ratio is maintained by reducing the concentration of the contaminants.

11. The method of claim 10 wherein the concentration of said contaminants is reduced by replacing a portion of said deposition solution with an equivalent amount of such solution which is essentially free of said contaminants.

12. The method of claim 9 wherein said intrinsic cathodic reaction rate is increased by increasing said copper ion concentration and/or by adding a depolarizer for the cathodic reaction.

13. The method of claims 1, 3 and 6, wherein said ratio is maintained by decreasing the intrinsic anodic reaction rate relative to the intrinsic cathodic reaction rate.

14. The method of claim 13, wherein said intrinsic anodic reaction rate is decreased by decreasing the concentration of said reducing agent for the copper ions and/or by lowering the concentration of constituents which depolarize said intrinsic anodic reaction.

15. The method of claims 2, 3 and 6, wherein said intrinsic anodic reaction rate is decreased by adjusting the concentration of either, or both, said formaldehyde and hydroxide ions so that the product of the formaldehyde concentration and the square root of the hydroxide concentration is decreased.

16. The method of claims 2, 3, and 6, wherein the constituents that reduce the intrinsic anodic reaction rate are selected from the group consisting of inorganic cyanides, organic nitriles, vanadium compounds, aromatic heterocyclic nitrogen compounds and polyoxyethylene compounds.

**Patentansprüche**

1. Ein Verfahren zum Abscheiden von im wesentlichen rißfreiem Kupfer auf einer Unterlage aus einer ohne äußere Stromzufuhr Kupfer abscheidenden Badlösung, bestehend aus Kupferionen, einem Bestandteil zum Einstellen des pH Wertes, einem Komplexbildner für Kupferionen und einem Reduktionsmittel für die Kupferionen, dadurch gekennzeichnet, daß das Verfahren die folgenden Schritte aufweist: Herstellen der genannten, ohne äußere Stromzufuhr Kupfer abscheidenden Badlösung und Betrieb derselben durch Einstellen der Konzentrationen der anodischen und kathodischen Reagenzien, so daß das Verhältnis ihrer gemessenen intrinsikanten anodischen Reaktionsgeschwindigkeit zu ihrer gemessenen intrinsikanten kathodischen Reaktionsgeschwindigkeit weniger als 1.1 beträgt, wobei die anodischen und kathodischen Reagenzien Badbestandteile sind, die an der anodischen bzw. an der kathodischen Reaktion beteiligt sind, und die das Verhältnis von intrinsikanter kathodischer Reaktionsgeschwindigkeit zu intrinsikanter anodischer Reaktionsgeschwindigkeit beeinflussen; sowie Abscheiden einer Kupferschicht mit der genannten, ohne äußere Stromzufuhr abscheidenden Badlösung auf der genannten Unterlage.

2. Das Verfahren nach Anspruch 1, bei dem das Reduktiosmittel Formaldehyd in Gegenwart von Hydroxylionen ist.

3. Ein Verfahren zum Einstellen und/oder zum Betrieb einer ohne äußere Stromzufuhr Kupfer abscheidenden Badlösung, um sicherzustellen, daß eine rißfreie Kupferschicht auf einer Unterlage abgeschieden wird, bei dem die genannte Badlösung Kupfer, einen oder mehrere Liganden, Formaldehyd, ein Alkalimetallhydroxid und einen oder mehrere Zusätze enthält, und das Verfahren die folgenden Schritte aufweist:
   a) Messen der intrinsikanten anodischen Reaktionsgeschwindigkeit der Abscheidungslösung;
   b) Messen der intrinsikanten kathodischen Reaktionsgeschwindigkeit der Lösung;
   c) Vergleichen der gemessenen Werte und Bestimmen, ob das Verhältnis der intrinsikanten anodischen Reaktionsgeschwindigkeit zur intrinsikanten kathodischen Reaktionsgeschwindigkeit weniger als 1.1 beträgt; und
   d) Einstellen der inneren Reaktionsgeschwindigkeiten, so daß das Verhältnis weniger als 1.1 beträgt.

4. Das Verfahren nach Anspruch 3, bei dem, nach dem Einstellen der inneren Reaktionsgeschwindigkeiten, die Schritte b) und c) wiederholt werden, um festzustellen, ob das Verhältnis weniger als 1.1 beträgt; und Wiederholen von Schritt d) und der Schritte b) und c), bis das gemessene Verhältnis weniger als 1.1 beträgt.

5. Das Verfahren nach Anspruch 4, bei dem das Verhältnis eingestellt wird durch Erhöhen des Verhältnisses von intrinsikanter kathodischer Reaktionsgeschwindigkeit relativ zur intrinsikanten anodischen Reaktionsgeschwindigkeit durch Erhöhen der Kupferkonzentration, durch Erhöhen der Konzentration eines oder mehrerer der Zusätze und/oder durch Reduzieren der Konzentration des Formaldehyds und/oder des Alkalimetallhydroxids.

6. Ein Verfahren zum Steuern des kommerziellen Betriebs einer ohne äußere Stromzufuhr Kupfer abscheidenden Badlösung, die Kupfer, einen oder mehrere Liganden, Formaldehyd, ein Alkalimetallhydroxid und einen oder mehrere Zusätze enthält, das die folgenden Schritte aufweist:
   a) Messen der intrinsikanten anodischen Reaktionsgeschwindigkeit und der intrinsikanten kathodischen Reaktionsgeschwindigkeit der Abscheidungslösung;
   b) Vergleichen der gemessenen Werte und Bestimmen, ob das Verhältnis der gemessenen intrinsikanten kathodischen Reaktionsgeschwindigkeit zur gemessenen intrinsikanten anodischen Reaktionsgeschwindigkeit weniger als 1.1 beträgt;
   c) Unterbrechen der kommerziellen Verwendung der Abscheidungslösung, es sei denn, das Verhältnis beträgt weniger als 1.1.

7. Das Verfahren nach Anspruch 6, das weiterhin die folgenden Schritte aufweist:
   d) Neueinstellen der intrinsikanten anodischen Reaktionsgeschwindigkeit und/oder der intrinsikanten anodischen Reaktionsgeschwindigkeit, so daß das Verhältnis auf den urspünglichen Wert der Badlösung zurückgebracht wird bzw. weniger als 1.1. beträgt;
   e) Wiederaufnahme der kommerziellen Verwendung der Abscheidungslösung.

8. Das Verfahren nach den Ansprüchen 1, 3 und 6, bei dem das Verhältnis weniger als 1.05 und vorzugsweise weniger als 1.0 beträgt.

9. Das Verfahren nach den Ansprüchen 1, 3 und 6, bei dem das Verhältnis aufrechterhalten wird durch Erhöhen der intrinsikanten kathodischen Reaktionsgeschwindigkeit relativ zur intrinsikanten anodischen Reaktionsgeschwindigkeit.

10. Das Verfahren nach Anspruch 9, bei dem die Abscheidungslösung einen oder mehrere vergiftende(n) Stoffe enthält und bei dem das Verhältnis aufrechterhalten wird durch Reduzieren der Konzentration der vergiftenden Stoffe.

11. Das Verfahren nach Anspruch 10, bei dem die Konzentration der vergiftenden Stoffe reduziert wird durch Ersetzen eines Teiles der Abscheidungslösung durch eine entsprechende Menge der gleichen Lösung, die im wesentlichen frei von vergiftenden Stoffen ist.

12. Das Verfahren nach Anspruch 9, bei dem die intrinsikante kathodische Reaktionsgeschwindigkeit erhöht wird durch Erhöhen der Kupferionen-Konzentration und/oder durch die Zugabe eines Depolarisationsmittels für die kathodische Reaktion.

13. Das Verfahren nach den Ansprüchen 1, 3 und 6, bei dem das Verhältnis aufrechterhalten wird durch Verringern der intrinsikanten anodischen Reaktionsgeschwindigkeit relativ zur intrinsikanten kathodischen Reaktionsgeschwindigkeit.

14. Das Verfahren nach Anspruch 13, bei dem die intrinsikante anodische Reaktionsgeschwindigkeit reduziert wird durch Verringern der Konzentration des Reduktionsmittels für die Kupferionen und/oder durch Herabsetzen der Konzentration der auf die intrinsikante anodische Reaktionsgeschwindigkeit depolarisierend wirkenden Badbestandteile.

15. Das Verfahren nach den Ansprüchen 2, 3 und 6, bei dem die intrinsikante anodische Reaktionsgeschwindigkeit reduziert wird durch Einstellen der Konzentration entweder des Formaldehyds und der Hydroxylionen, oder beider, so daß das Produkt aus der Formaldehyd-Konzentration und der Quadratwurzel der Hydroxylionen-Konzentration herabgesetzt wird.

16. Das Verfahren nach den Ansprüchen 2, 3 und 6, bei dem die Bestandteile, die die intrinsikante anodische Reaktionsgeschwindigkeit herabsetzen, ausgewählt sind aus der Gruppe bestehend aus anorganischen Cyaniden, organischen Nitrilen, Vanadium-Verbindungen, aromatischen heterozyklischen Stickstoffverbindungen und Polyoxyethlen-Verbindungen.

**Revendications**

1. Procédé pour déposer du cuivre qui est essentiellement dépourvu de fissures sur un substrat à l'aide d'une solution de dépôt chimique de cuivre comprenant des ions cuivre, un produit permettant de régler le pH, un ligand pour les ions cuivre et un agent réducteur pour les ions cuivre, caractérisé en ce que le procédé comprend la préparation de la solution de dépôt chimique de cuivre et la mise en service de la solution en réglant les concentrations des réactifs anodiques et cathodiques de façon à ce que le rapport de sa vitesse de réaction anodique intrinsèque mesurée à sa vitesse de réaction cathodique intrinsèque mesurée soit inférieur à 1,1, grâce à quoi les réactifs anodiques et cathodiques sont des constituants du bain qui participent respectivement à la réaction anodique et à la réaction cathodique et agissent respectivement sur la vitesse de réaction cathodique intrinsèque et sur la vitesse de réaction anodique intrinsèque ; et le dépôt du cuivre à l'aide de la solution de dépôt chimique sur le substrat.

2. Procédé selon la revendication 1, dans lequel l'agent réducteur est le formaldéhyde en présence d'ions hydroxyde.

3. Procédé de réglage et/ou de mise en service d'une solution de dépôt chimique de cuivre pour être sûr qu'elle déposera du cuivre dépourvu de fissures sur un substrat, la solution comprenant du cuivre, un ou plusieurs ligands, du formaldéhyde, un hydroxyde de métal alcalin et un ou plusieurs additifs, ce

**EP 0 265 895 B1**

procédé comprenant les étapes de

    a) mesure de la vitesse de réaction anodique intrinsèque de la solution de dépôt;

    b) mesure de la vitesse de réaction cathodique intrinsèque de la solution ;

    c) comparaison des vitesses mesurées pour déterminer si le rapport de la vitesse de réaction anodique intrinsèque à la vitesse de réaction cathodique intrinsèque est inférieur à 1,1 ; et

    d) réglage des vitesses de réactions intrinsèques de façon à ce que le rapport soit inférieur à 1,1.

**4.** Procédé selon la revendication 3, dans lequel, après le réglage du rapport des vitesses de réactions intrinsèques, on répète les étapes b) et c) pour déterminer si le rapport est inférieur à 1,1 ; et on répète l'étape d) et les étapes b) et c) jusqu'à ce que le rapport mesuré soit inférieur à 1,1.

**5.** Procédé selon la revendication 4, dans lequel on règle le rapport en augmentant le rapport de la vitesse de réaction cathodique intrinsèque à la vitesse de réaction anodique intrinsèque en augmentant la concentration du cuivre, en augmentant la concentration d'un ou plusieurs des additifs et/ou en diminuant la concentration du formaldéhyde et/ou de l'hydroxyde de métal alcalin.

**6.** Procédé pour régler la mise en service commerciale d'une solution de dépôt chimique de cuivre, comprenant du cuivre, un ou plusieurs ligands, du formaldéhyde, un hydroxyde de métal alcalin, et un ou plusieurs additifs, comprenant les étapes de

    a) mesure de la vitesse de réaction anodique intrinsèque et de la vitesse de réaction cathodique intrinsèque de la solution de dépôt ;

    b) comparaison des vitesses mesurées pour déterminer si le rapport de la vitesse de réaction cathodique intrinsèque mesurée à la vitesse de réaction anodique intrinsèque mesurée est inférieure à 1,1 ;

    c) arrêt de l'utilisation commerciale de la solution de dépôt à moins que le rapport soit inférieur à 1,1.

**7.** Procédé selon la revendication 6, comprenant en outre les étapes de

    d) réajustage de la vitesse de réaction anodique intrinsèque et/ou de la vitesse de réaction cathodique intrinsèque de façon à ce que le rapport revienne à la valeur d'origine du rapport de la solution ou soit inférieur à 1,1 ; et

    e) reprise de l'utilisation commerciale de la solution de dépôt.

**8.** Procédé selon les revendications 1, 3 et 6, dans lequel le rapport est inférieur à 1,05 et de préférence inférieur à 1,0.

**9.** Procédé selon les revendications 1, 3 et 6, dans lequel on maintient ce rapport en augmentant la vitesse cathodique intrinsèque par rapport à la vitesse anodique intrinsèque.

**10.** Procédé selon la revendication 9, dans lequel la solution de dépôt contient une ou plusieurs impuretés et dans lequel on maintient le rapport en diminuant la concentration des impuretés.

**11.** Procédé selon la revendication 10, dans lequel on diminue la concentration des impuretés en remplaçant une partie de la solution de dépôt par une quantité équivalente de la solution qui est essentiellement dépourvue de ces impuretés.

**12.** Procédé selon la revendication 9, dans lequel on augmente la vitesse de réaction cathodique intrinsèque en augmentant la concentration en ions cuivre et/ou en ajoutant un dépolarisant pour la réaction cathodique.

**13.** Procédé selon les revendications 1, 3 et 6, dans lequel on maintient le rapport en diminuant la vitesse de réaction anodique intrinsèque par rapport à la vitesse de réaction cathodique intrinsèque.

**14.** Procédé selon la revendication 13, dans lequel on diminue la vitesse de réaction anodique intrinsèque en diminuant la concentration de l'agent réducteur pour les ions cuivre et/ou en abaissant la concentration de constituants qui dépolarisent la réaction anodique intrinsèque.

**15.** Procédé selon les revendications 2, 3 et 6, dans lequel on diminue la vitesse de réaction anodique

28

intrinsèque en réglant la concentration du formaldéhyde ou des ions hydroxydes ou des deux de manière à diminuer le produit de la concentration du formaldéhyde et de la racine carrée de la concentration de l'hydroxyde.

16. Procédé selon les revendications 2, 3 et 6, dans lequel les constituants qui diminuent la vitesse de réaction anodique intrinsèque sont choisis dans le groupe constitué par des cyanures inorganiques, des nitriles organiques, des composés du vanadium, des composés aromatiques hétérocycliques azotés et des composés de polyoxyéthylène.

FIG. 1

FIG. 2

FIG. 3

31